(19) Europäisches Patentamt
European Patent Office
Office européen des brevets

(11) EP 3 373 335 A2

(12) EUROPEAN PATENT APPLICATION

(43) Date of publication:
12.09.2018 Bulletin 2018/37

(51) Int Cl.:
H01L 27/16 (2006.01)    H01L 35/32 (2006.01)

(21) Application number: 18151176.7

(22) Date of filing: 11.01.2018

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD TN

(30) Priority: 10.03.2017 KR 20170030748

(71) Applicant: Center For Advanced Soft Electronics
Pohang-si, Gyeongsangbuk-do 37673 (KR)

(72) Inventors:
• CHO, Kilwon
37673 GYEONGSANGBUK-DO (KR)
• KIM, Dae Gun
10448 GYEONGGI-DO (KR)
• JU, Duck Hyun
37663 GYEONGSANGBUK-DO (KR)

(74) Representative: EP&C
P.O. Box 3241
2280 GE Rijswijk (NL)

(54) **THERMOELECTRIC DEVICE AND METHOD OF MANUFACTURING THE SAME**

(57) Disclosed is a thermoelectric device, including a flexible substrate having a zigzag configuration in which a vertical cross-section in a longitudinal direction of one surface thereof includes peaks and valleys and a thermoelectric material line positioned on the flexible substrate and configured to include a p-type thermoelectric material and any one of an n-type thermoelectric material and an electrode material, which are alternately continuously disposed, wherein any one of the n-type thermoelectric material and the electrode material is in contact with the p-type thermoelectric material at the peaks and the valleys. The thermoelectric device, having a zigzag configuration, is highly flexible and lightweight, and a thermoelectric material in film form can be utilized to realize a vertical temperature difference, and thus the thickness of the device can be freely adjusted regardless of the film thickness, thereby easily maintaining a large temperature difference even without a heat sink.

Fig. 1A

EP 3 373 335 A2

**Description**

BACKGROUND OF THE INVENTION

1. Technical Field

The present invention relates to a thermoelectric device and a method of manufacturing the same, and more particularly to a thermoelectric device having a zigzag configuration including peaks and valleys and a method of manufacturing the same.

2. Description of the Related Art

Thermoelectric conversion indicates energy conversion between thermal energy and electrical energy. Thermoelectric conversion is represented by a Peltier effect in which, when current is allowed to flow to a thermoelectric material, a temperature difference is formed between the opposite ends thereof, and conversely by a Seebeck effect, in which electricity is generated when there is a temperature difference at opposite ends of a thermoelectric material.

When a Seebeck effect is applied, heat generated from computers, automotive engines, industrial plants, etc. may be converted into electrical energy. Thermoelectric power generation using such a Seebeck effect may be utilized as a renewable energy source. Recently, with increased interest in new energy development, recovery of waste energy and environmental protection, thermoelectric devices are receiving attention.

Currently useful thermoelectric materials having high performance are mostly composed of semiconductor metal materials or ceramic materials. Such materials have excellent thermoelectric properties but mostly have high density and thus are disadvantageous in that they are heavy when used in large amounts in order to produce high power. Furthermore, almost all semiconductor metal materials or ceramic materials are expensive, and the processing thereof includes high-temperature and highpressure processes, thus increasing processing costs, making it difficult to realize large-area production. Hence, there are limits to the extent to which the weight of such thermoelectric devices using the corresponding materials can be reduced and to which the shape thereof can be changed, and breakdown may occur upon vibration or impact due to the high brittleness thereof, which is undesirable.

SUMMARY OF THE INVENTION

Accordingly, the present invention has been made keeping in mind the problems encountered in the related art, and the present invention is intended to provide a thermoelectric device, in which a zigzag configuration including peaks and valleys is introduced to the device, and thus, even when a thermoelectric material is thin, the thickness of the device may increase, and which may employ a vertical temperature difference and which is highly flexible and lightweight.

In addition, the present invention is intended to provide a method of manufacturing a thermoelectric device, which enables large-area production at low processing cost using a solution process.

Therefore, an aspect of the present invention provides a thermoelectric device, comprising: a flexible substrate having a zigzag configuration in which a vertical cross-section in a longitudinal direction of one surface thereof includes peaks and valleys; and a thermoelectric material line positioned on the flexible substrate and configured to include a p-type thermoelectric material and any one of an n-type thermoelectric material and an electrode material, which are alternately continuously disposed in the longitudinal direction of one surface of the flexible substrate, wherein any one of the n-type thermoelectric material and the electrode material is in contact with the p-type thermoelectric material at the peaks and the valleys.

The thermoelectric device may further include a thermal insulator, the thermal insulator being positioned between respective valleys and between respective peaks.

The thermal insulator may include at least one selected from among polyurethane foam, silica aerogel, polydimethylsiloxane foam, polystyrene, fiberglass, and cork.

The thermoelectric material line may be configured such that any one of the n-type thermoelectric material and the electrode material is spaced apart from the p-type thermoelectric material in the width direction of one surface of the flexible substrate.

The p-type thermoelectric material may include at least one selected from among PEDOT:PSS (poly(3,4-ethylenedioxythiophene):polystyrene sulfonate), polyacetylene, polyaniline, polypyrrole, polythiophene, polycarbazole, polyphenylenevinylene, and carbon nanotubes.

The n-type thermoelectric material may include at least one selected from among bismuth telluride ($Bi_2Te_3$), antimony telluride ($Sb_2Te_3$), lead telluride (PbTe), cobalt antimonide ($CoSb_a$), TTF-TCNQ (tetrathiafulvalene-tetracyanoquinodimethane), poly(metal 1,1,2,2-ethenetetrathiolate), and titanium disulfide.

The electrode material may include at least one selected from among titanium (Ti), gold (Au), silver (Ag), nickel (Ni), copper (Cu), platinum (Pt), chromium (Cr), aluminum (Al), zinc (Zn), and iron (Fe).

The flexible substrate may include at least one selected from among PET (polyethylene terephthalate), PEN (polyethylene naphthalate), PI (polyimide), PC (polycarbonate), PAR (polyarylate), and PES (polyethersulfone).

Another aspect of the present invention provides a method of manufacturing a thermoelectric device, comprising: (a) patterning a flexible substrate so that a p-type thermoelectric material and any one of an n-type thermoelectric material and an electrode material are alternately continuously disposed thereon, thus preparing a patterned flexible substrate; and (b) shaping the patterned flexible substrate so as to have a zigzag configuration in which a vertical cross-section in a longitudinal direction of one surface thereof includes peaks and valleys, thus forming a thermoelectric device, wherein any one of the n-type thermoelectric material and the electrode material is in contact with the p-type thermoelectric material at the peaks and the valleys.

The method may further include (c) positioning a thermal insulator between respective valleys and between respective peaks of the thermoelectric device, after step (b).

The thermal insulator may include at least one selected from among polyurethane foam, silica aerogel, polydimethylsiloxane foam, polystyrene, fiberglass, and cork.

The p-type thermoelectric material may include at least one selected from among PEDOT:PSS (poly(3,4-ethylenedioxythiophene):polystyrene sulfonate), polyacetylene, polyaniline, polypyrrole, polythiophene, polycarbazole, polyphenylenevinylene, and carbon nanotubes.

The n-type thermoelectric material may include at least one selected from among bismuth telluride ($Bi_2Te_3$), antimony telluride ($Sb_2Te_3$), lead telluride (PbTe), cobalt antimonide ($CoSb_a$), TTF-TCNQ (tetrathiafulvalene-tetracyanoquinodimethane), poly(metal 1,1,2,2-ethenetetrathiolate), and titanium disulfide.

The electrode material may include at least one selected from among titanium (Ti), gold (Au), silver (Ag), nickel (Ni), copper (Cu), platinum (Pt), chromium (Cr), aluminum (Al), zinc (Zn), and iron (Fe).

The flexible substrate may include at least one selected from among PET (polyethylene terephthalate), PEN (polyethylene naphthalate), PI (polyimide), PC (polycarbonate), PAR (polyarylate), and PES (polyethersulfone).

According to the present invention, a thermoelectric device has a zigzag configuration including peaks and valleys, and thus a thermoelectric material in film form can be utilized to realize a vertical temperature difference, and the thickness of the device can be freely adjusted regardless of the thickness of the film, making it easy to maintain a large temperature difference even without the use of a heat sink. Furthermore, the device is highly flexible and lightweight.

Moreover, a method of manufacturing the thermoelectric device according to the present invention enables large-area production at low processing cost using a solution process.

BRIEF DESCRIPTION OF DRAWINGS

FIGS. 1A and 1B schematically show thermoelectric devices according to two embodiments of the present invention;

FIGS. 2A and 2B show the results of measurement of power output properties of the thermoelectric devices manufactured in Examples 1 and 2;

FIGS. 3A and 3B show the results of simulation of temperature gradient of the thermoelectric devices manufactured in Examples 1 and 2; and

FIGS. 4A and 4B show the results of testing of flexibility of the thermoelectric device manufactured in Example 2.

DESCRIPTION OF SPECIFIC EMBODIMENTS

The present invention may be embodied in many different forms and should not be construed as being limited only to the embodiments set forth herein, but should be understood to cover all modifications, equivalents or alternatives falling within the ideas and technical scope of the present invention. In the description of the present invention, detailed descriptions of related known techniques incorporated herein will be omitted when the same may make the gist of the present invention unclear.

As used herein, the terms "first", "second", etc. may be used to describe various elements, but these elements are not to be limited by these terms. These terms are only used to distinguish one element from another. For example, a first element may be termed a second element, and, similarly, a second element may be termed a first element, without departing from the scope of the present invention.

Further, it will be understood that when an element is referred to as being "formed" or "layered" "on" another element, it can be formed or layered so as to be directly attached to the entire surface or one surface of the other element, or intervening elements may be present therebetween.

Unless otherwise stated, the singular expression includes a plural expression. In this application, the terms "include" or "have" are used to designate the presence of features, numbers, steps, operations, elements, parts, or combinations thereof described in the specification, and should be understood as not excluding the presence or additional possible presence of one or more different features, numbers, steps, operations, elements, parts, or combinations thereof.

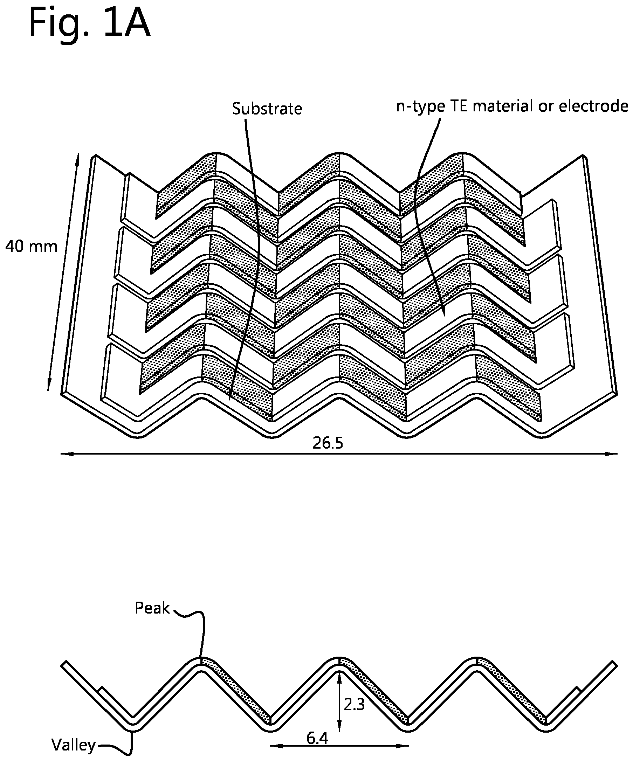

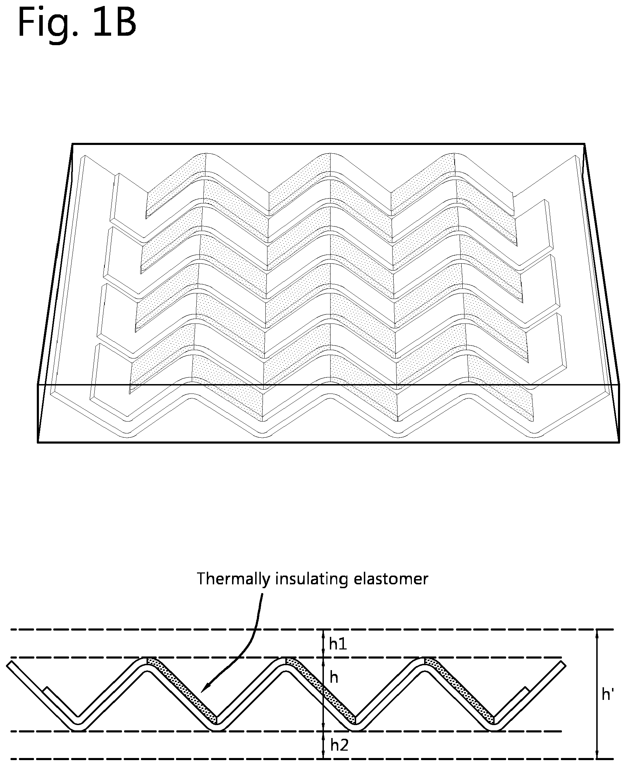

FIG. 1A schematically shows a thermoelectric device according to one embodiment of the present invention and FIG. 1B schematically shows a thermoelectric device according to another embodiment of the present invention. Here, all numeric values of the thermoelectric device, such as length, height, and the like, are given by way of example, and the present invention is not limited thereby, and is to be defined only by the scope of the accompanying claims.

Hereinafter, a thermoelectric device of the present invention is described with reference to FIGS.

1A and 1B.

The present invention addresses a thermoelectric device, comprising: a flexible substrate having a zigzag configuration in which a vertical cross-section in a longitudinal direction of one surface thereof includes peaks and valleys; and a thermoelectric material line positioned on the flexible substrate and configured to include a p-type thermoelectric material and any one of an n-type thermoelectric material and an electrode material, which are alternately continuously disposed in the longitudinal direction of one surface of the flexible substrate.

Here, any one of the n-type thermoelectric material and the electrode material may be in contact with the p-type thermoelectric material at the peaks and the valleys.

The zigzag configuration may be a Chevron shape or a wave shape.

When a temperature difference occurs in the thermoelectric device, holes and electrons in the p-type and n-type thermoelectric materials are moved to a high-temperature portion and a low-temperature portion, respectively, thus generating electromotive force. In order to cause a temperature difference in a thin device, a heat sink has to be attached to the surface of the device opposite the surface that comes into contact with a heat source. However, the heat sink is problematic because it consumes power or increases the volume and weight, making it difficult to actually apply the same to thermoelectric power generation. Meanwhile, a horizontal temperature difference is difficult to realize when the thermoelectric device is actually used, and in order to use the thermoelectric device attached to the surface of a specific heat source, a vertical temperature difference has to be employed. To realize thermoelectric power generation using the vertical temperature difference, the thickness of the thermoelectric device should be at least on the order of ones of mm so that a temperature difference of 10°C or more is maintained in air.

In the thermoelectric device of the present invention, the flexible substrate, having a zigzag configuration in which a vertical cross-section in a longitudinal direction of one surface thereof includes peaks and valleys, is used, and thereby, even when the p-type thermoelectric material and any one of the n-type thermoelectric material and the electrode material are formed to a thickness of tens of $\mu$m, the thickness of the thermoelectric device may be on the order of ones of mm due to a height difference between the peaks and the valleys of the flexible substrate.

The p-type thermoelectric material may be used without limitation so long as it may be subjected to a solution process, and preferably includes PEDOT:PSS (poly(3,4-ethylenedioxythiophene):polystyrene sulfonate), polyacetylene, polyaniline, polypyrrole, polythiophene, polycarbazole, polyphenylenevinylene, and carbon nanotubes. Particularly used is PEDOT:PSS.

As the material that is alternately continuously disposed with the p-type thermoelectric material, the n-type thermoelectric material or the electrode material may be used without limitation so long as it may be subjected to a solution process. Preferably used is a material having high resistance to oxidation due to oxygen.

The n-type thermoelectric material may include bismuth telluride ($Bi_2Te_3$), antimony telluride ($Sb_2Te_3$), lead telluride (PbTe), cobalt antimonide ($CoSb_a$), TTF-TCNQ (tetrathiafulvalene-tetracyanoquinodimethane), poly(metal 1,1,2,2-ethenetetrathiolate), and titanium disulfide. Preferably used is bismuth telluride.

The electrode material may include titanium (Ti), gold (Au), silver (Ag), nickel (Ni), copper (Cu), platinum (Pt), chromium (Cr), aluminum (Al), zinc (Zn), and iron (Fe). Preferably, both titanium and gold are used at the same time.

The material for the flexible substrate may be used without limitation, so long as it has high flexibility and may be subjected to a shaping process, and preferably includes PET (polyethylene terephthalate), PEN (polyethylene naphthalate), PI (polyimide), PC (polycarbonate), PAR (polyarylate) and PES (polyethersulfone). More preferably used is PET.

The thermoelectric material line may be configured such that any one of the n-type thermoelectric material and the electrode material may be spaced apart from the p-type thermoelectric material in the width direction of one surface of the flexible substrate. Thereby, holes and electrons may flow along the thermoelectric material line.

With reference to FIGS. 1A and 1B, the thermoelectric device may further include a thermal insulator. The thermal insulator may be positioned between respective valleys and between respective peaks.

As described above, it is preferred that the thermoelectric device have a large vertical temperature difference. To this end, the thermal insulator is disposed between respective valleys and between respective peaks, thereby further increasing the temperature difference of the thermoelectric device.

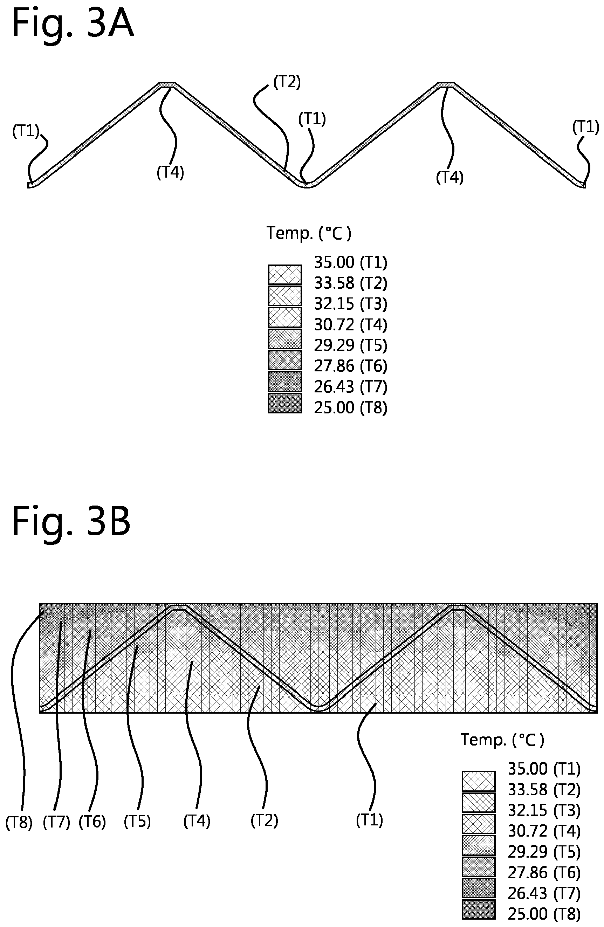

With reference to FIG. 1B and FIG. 3A, the effect of the thickness of the thermal insulator is described based on Equation 1 below.

$$[Equation\ 1]$$

$$r = h'/h$$

In Equation 1, $h'=h+h_1+h_2$, and h is the vertical height from the peak to the valley, h' is the thickness of the thermal insulator, $h_1$ is the vertical distance to the surface of the thermal insulator that is close to the peak, and $h_2$ is the vertical distance to the surface of the thermal insulator that is close to the valley.

Here, r is not particularly limited, and falls in the range of 1 to 2, preferably 1 to 1.5, and more preferably 1 to 1.1, and is much more preferably 1. If r is less than 1 ($h_1$ or $h_2 < 0$), the valleys or the peaks are exposed to the outside. The exposed valley portions do not substantially participate in power production because almost no temperature difference is formed. In the case where the peaks are exposed, the temperature difference is mostly formed near the peaks of the device in the absence of the thermal insulator (FIG. 3A), and thus only an insignificant temperature difference is formed on the top of the device including the thermal insulator, which is undesirable. On the other hand, if r exceeds 2 ($h_1$, $h_2 > 0$), the valleys or peaks are completely covered with the thermal insulator. As such, the temperature difference is formed throughout the thermal insulator and the device uses only a portion of the temperature difference and thus the maximum temperature difference that may be formed in the device is limited, which is undesirable.

As the thermal insulator, any material may be used so long as it has low thermal conductivity and is flexible, and preferably includes polyurethane foam, silica aerogel, polydimethylsiloxane foam, polystyrene, fiberglass, and cork. More preferably used is polyurethane foam.

Below is a description of a method of manufacturing the thermoelectric device according to the present invention.

Specifically, a flexible substrate is patterned so that a p-type thermoelectric material and any one of an n-type thermoelectric material and an electrode material are alternately continuously disposed thereon, thus preparing a patterned flexible substrate (step a).

The p-type thermoelectric material and any one of the n-type thermoelectric material and the electrode material may be materials that are capable of being subjected to a solution process. The specific examples thereof remain the same as in the above description of the thermoelectric device.

Finally, the patterned flexible substrate is shaped so as to have a zigzag configuration in which the vertical cross-section in the longitudinal direction of one surface thereof includes peaks and valleys, thus forming the thermoelectric device (step b).

Preferably, a shaping process is performed so that any one of the n-type thermoelectric material and the electrode material comes into contact with the p-type thermoelectric material at the peaks and the valleys, and the shaping process may be carried out by placing the patterned flexible substrate between pressing plates and then applying heat thereto. Here, the temperature of the heat falls in the range of 100 to 200°C, preferably 120 to 180°C, and more preferably 140 to 160°C. Also, the period of time for which it is required to apply heat may vary depending on the temperature of the heat, and preferably ranges from 30 sec to 2 min, and more preferably from 45 sec to 1 min 30 sec. For reference, the heat is slowly increased from room temperature at a rate of about 1 °C/min, and thus degradation (breakage) and delamination (exfoliation) of the patterned flexible substrate may be prevented from occurring owing to thermal expansion in response to drastic changes in temperature. Furthermore, the period of time required to apply heat from the time point at which the target temperature is reached is adjusted.

Additionally, a thermal insulator may be positioned between respective valleys and between respective peaks of the thermoelectric device (step c).

The thermal insulator functions to increase a vertical temperature difference of the thermoelectric device, as described above, and the material for the thermal insulator remains the same as in the above description of the thermoelectric device.

[Examples]

A better understanding of the present invention will be conveyed through a description of preferred embodiments, which are set forth to illustrate but are not to be construed to limit the scope of the present invention.

Example 1

A PET flexible substrate having a width of 40 mm and a length of 40 mm was patterned so that PEDOT:PSS, serving as a p-type thermoelectric material, and titanium (Ti) 10 nm/gold (Au) 60 nm, serving as an electrode material, were alternately continuously disposed thereon to form 24 PEDOT:PSS patterns. Before the PEDOT:PSS patterning, the wettability of the surface of PET was improved through RIE treatment (250 W, $O_2$ 100 sccm, 2 min), and the PEDOT:PSS patterns were obtained by coating a shadow mask-covered PET flexible substrate with a PEDOT:PSS thin film having a thickness of less than 100 nm using a gas spray and then increasing the thickness thereof to about 2 to 3 $\mu$m through electrospraying. Thereafter, annealing at 150°C for 20 min and then dipping in ethylene glycol for 1 hr were conducted, and the device taken out of the ethylene glycol was washed with ethanol and blown using nitrogen ($N_2$) gas. Next, the patterned flexible substrate was placed between pressing plates and heat at 150°C was applied thereto for 1 min, thereby manufacturing a thermoelectric device having a zigzag configuration including peaks and valleys, which is illustrated in FIG. 1A.

Example 2

The top and bottom of the thermoelectric device of Example 1 were fixed with silicone grease-coated glass, after which polyurethane and a foaming agent in solution phase were mixed at a ratio of 11:10 and then poured into the thermoelectric device. The reaction was carried out at room temperature for one day or longer, thus forming polyurethane foam, from which the glass was then removed, thereby manufacturing a thermoelectric device filled with the polyurethane foam, which is illustrated in FIG. 1B.

[Test Examples]

Test Example 1: Measurement of power output of thermoelectric device

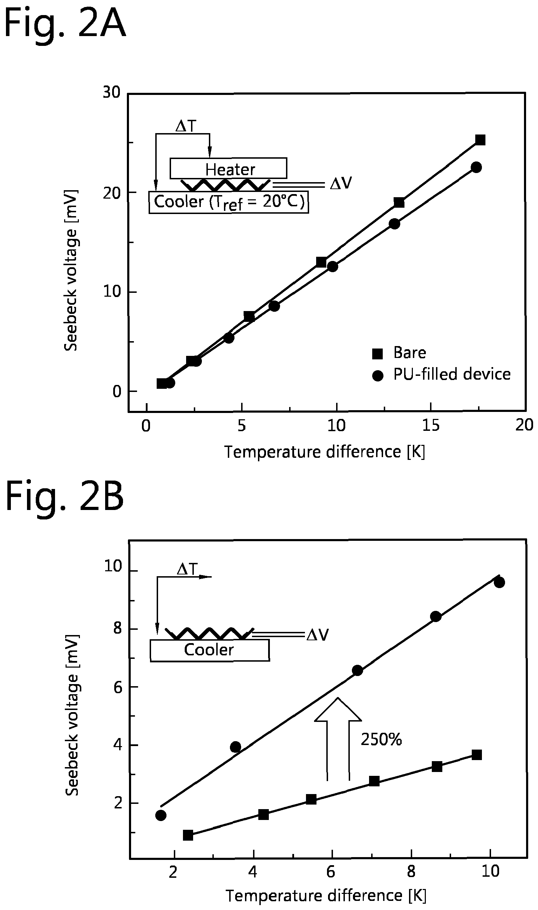

FIG. 2A shows the results of measurement of power output of the thermoelectric device (Bare) of Example 1 and the thermoelectric device (PU-filled device) of Example 2 in the presence of the heat sink, and FIG. 2B shows the results of measurement of power output in air in the absence of the heat sink.

FIG. 2A shows the electromotive force measured when the temperature difference generated in the thermoelectric device including the heat sink attached thereto was fixed, and in order to evaluate thermoelectric properties of the p-type thermoelectric material PEDOT:PSS, the temperature loss due to the flexible substrate was corrected. The Seebeck coefficient of the p-type thermoelectric material PEDOT:PSS film is about 60 $\mu$V/K, and the thermoelectric devices of Example 1 (Bare) and Example 2 (PU-filled device), comprising 24 PEDOT:PSS patterns, should show a theoretical power output of 1.44 mV/K. As shown in the drawings, both the thermoelectric devices of Example 1 (Bare) and Example 2 (PU-filled device) exhibited numeric values very close to the theoretical power output of 1.44 mV/K, regardless of the presence or absence of the polyurethane foam.

Thus, it can be found that the zigzag configuration including peaks and valleys of the thermoelectric devices of Example 1 (Bare) and Example 2 (PU-filled device) is capable of efficiently maintaining the thermoelectric properties of the p-type thermoelectric material.

FIG. 2B shows the electromotive force measured after the removal of the heat sink, in which the temperature difference of the graph indicates the difference between the surface of a cooler and the atmospheric temperature. The thermoelectric device of Example 2 (PU-filled device) showed a power output of 1.0 mV/K, whereas the thermoelectric device of Example 1 (Bare) exhibited a low power output of 0.3 mV/K.

Therefore, in the absence of the heat sink, there was at least an approximately three-fold power difference depending on whether or not the polyurethane foam, serving as the thermal insulator, was provided.

Test Example 2: Temperature gradient simulation depending on presence or absence of thermal insulator

FIGS. 3A and 3B shows the results of simulation of a temperature gradient when the thermoelectric devices of Examples 1 and 2 were positioned in an atmosphere at 25°C under the condition that the temperature of the bottom thereof was fixed to 35°C. The thermal conductivity values of the PET substrate and the polyurethane foam were assumed to be 0.1 W m$^{-1}$K$^{-1}$ and 0.02 W m$^{-1}$K$^{-1}$, respectively. In FIG. 3A, the surface of the device exposed to the atmosphere is assumed to undergo convection due to the 25°C atmospheric temperature (a heat transfer coefficient of 30 W m$^{-2}$K$^{-1}$), and the lower surface thereof, opposite thereto, is assumed to undergo convection due to the 35°C atmospheric temperature. In the temperature simulation of FIG. 3B, all exposed surfaces are assumed to undergo convection due to the 25°C atmospheric temperature.

With reference to FIGS. 3A and 3B, the temperature gradient of the thermoelectric device of Example 2 including the polyurethane foam insulator (FIG. 3B) was much greater than that of the thermoelectric device of Example 1 including no polyurethane foam insulator (FIG. 3A). In the simulation of FIG. 3B, the temperature gradient appeared uniform, from which minimization of the voltage loss due to a portion of the thermoelectric material pattern having no temperature difference can be anticipated.

Therefore, the polyurethane foam can be confirmed to play an important role in maintaining a large temperature difference even without the heat sink.

Test Example 3: Measurement of flexibility

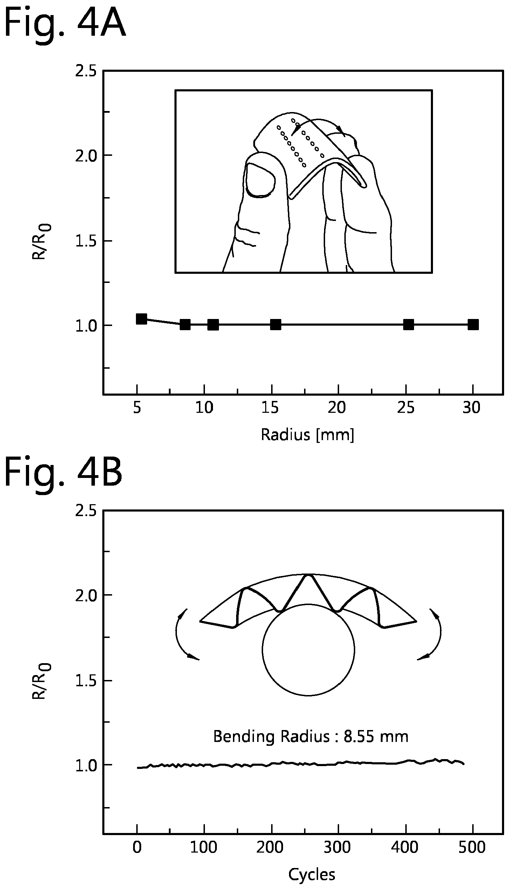

FIG. 4A shows the results of measurement of changes in resistance depending on the bending radius of the thermoelectric device of Example 2, and FIG. 4B shows the results of measurement of changes in resistance depending on the number of bending processes.

With reference to FIGS. 4A and 4B, the thermoelectric device of Example 2 was little changed in resistance even when the bending radius was increased to 30 mm. Also, even when the number of bending processes was increased to 500, changes in resistance hardly appeared.

Therefore, the thermoelectric device of Example 2 exhibited high flexibility even when including the polyurethane foam.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A thermoelectric device, comprising:

   a flexible substrate having a zigzag configuration in which a vertical cross-section in a longitudinal direction of one surface thereof includes peaks and valleys; and
   a thermoelectric material line positioned on the flexible substrate and configured to include a p-type thermoelectric material and any one of an n-type thermoelectric material and an electrode material, which are alternately continuously disposed in the longitudinal direction of the one surface of the flexible substrate,
wherein the any one of the n-type thermoelectric material and the electrode material is in contact with the p-type thermoelectric material at the peaks and the valleys.

2. The thermoelectric device of claim 1, further comprising a thermal insulator,
the thermal insulator being positioned between respective valleys and between respective peaks.

3. The thermoelectric device of claim 2, wherein the thermal insulator includes at least one selected from among polyurethane foam, silica aerogel, polydimethylsiloxane foam, polystyrene, fiberglass, and cork.

4. The thermoelectric device of claim 1, wherein the thermoelectric material line is configured such that the any one of the n-type thermoelectric material and the electrode material is spaced apart from the p-type thermoelectric material in a width direction of the one surface of the flexible substrate.

5. The thermoelectric device of claim 1, wherein the p-type thermoelectric material includes at least one selected from among PEDOT:PSS (poly(3,4-ethylenedioxythiophene):polystyrene sulfonate), polyacetylene, polyaniline, polypyrrole, polythiophene, polycarbazole, polyphenylenevinylene, and carbon nanotubes.

6. The thermoelectric device of claim 1, wherein the n-type thermoelectric material includes at least one selected from among bismuth telluride ($Bi_2Te_3$), antimony telluride ($Sb_2Te_3$), lead telluride (PbTe), cobalt antimonide ($CoSb_a$), TTF-TCNQ (tetrathiafulvalene-tetracyanoquinodimethane), poly(metal 1,1,2,2-ethenetetrathiolate), and titanium disulfide.

7. The thermoelectric device of claim 1, wherein the electrode material includes at least one selected from among titanium (Ti), gold (Au), silver (Ag), nickel (Ni), copper (Cu), platinum (Pt), chromium (Cr), aluminum (Al), zinc (Zn), and iron (Fe) .

8. The thermoelectric device of claim 1, wherein the flexible substrate includes at least one selected from among PET (polyethylene terephthalate), PEN (polyethylene naphthalate), PI (polyimide), PC (polycarbonate), PAR (polyarylate), and PES (polyethersulfone) .

9. A method of manufacturing a thermoelectric device, comprising:

(a) patterning a flexible substrate so that a p-type thermoelectric material and any one of an n-type thermoelectric material and an electrode material are alternately continuously disposed thereon, thus preparing a patterned flexible substrate; and
(b) shaping the patterned flexible substrate so as to have a zigzag configuration in which a vertical cross-section in a longitudinal direction of one surface thereof includes peaks and valleys, thus forming a thermoelectric device,

wherein the any one of the n-type thermoelectric material and the electrode material is in contact with the p-type thermoelectric material at the peaks and the valleys.

10. The method of claim 9, further comprising (c) positioning a thermal insulator between respective valleys and between respective peaks of the thermoelectric device, after step (b).

11. The method of claim 10, wherein the thermal insulator includes at least one selected from among polyurethane foam, silica aerogel, polydimethylsiloxane foam, polystyrene, fiberglass, and cork.

12. The method of claim 9, wherein the p-type thermoelectric material includes at least one selected from among PEDOT:PSS (poly(3,4-ethylenedioxythiophene):polystyrene sulfonate), polyacetylene, polyaniline, polypyrrole, polythiophene, polycarbazole, polyphenylenevinylene, and carbon nanotubes.

13. The method of claim 9, wherein the n-type thermoelectric material includes at least one selected from among bismuth telluride ($Bi_2Te_3$), antimony telluride ($Sb_2Te_3$), lead telluride (PbTe), cobalt antimonide ($CoSb_a$), TTF-TCNQ (tetrathiafulvalene-tetracyanoquinodimethane), poly(metal 1,1,2,2-ethenetetrathiolate), and titanium disulfide.

14. The method of claim 9, wherein the electrode material includes at least one selected from among titanium (Ti), gold (Au), silver (Ag), nickel (Ni), copper (Cu), platinum (Pt), chromium (Cr), aluminum (Al), zinc (Zn), and iron (Fe).

15. The method of claim 9, wherein the flexible substrate includes at least one selected from among PET (polyethylene terephthalate), PEN (polyethylene naphthalate), PI (polyimide), PC (polycarbonate), PAR (polyarylate), and PES (polyethersulfone).

# Fig. 1A

Substrate         n-type TE material or electrode

40 mm

26.5

Peak

Valley

2.3

6.4

# Fig. 1B

Thermally insulating elastomer

h1

h

h2

h'

## Fig. 2A

## Fig. 2B

# Fig. 3A

(T2)

(T1)

(T1)

(T1)

(T4)

(T4)

Temp. (°C)

| | |
|---|---|
| | 35.00 (T1) |
| | 33.58 (T2) |
| | 32.15 (T3) |
| | 30.72 (T4) |
| | 29.29 (T5) |
| | 27.86 (T6) |
| | 26.43 (T7) |
| | 25.00 (T8) |

# Fig. 3B

(T8) (T7) (T6)  (T5)    (T4)     (T2)       (T1)

Temp. (°C)

| | |
|---|---|
| | 35.00 (T1) |
| | 33.58 (T2) |
| | 32.15 (T3) |
| | 30.72 (T4) |
| | 29.29 (T5) |
| | 27.86 (T6) |
| | 26.43 (T7) |
| | 25.00 (T8) |

# Fig. 4A

# Fig. 4B

Bending Radius : 8.55 mm